Europäisches Patentamt

European Patent Office

Office européen des brevets

(11) Veröffentlichungsnummer: **0 209 144 B1**

# EUROPÄISCHE PATENTSCHRIFT

(45) Veröffentlichungstag der Patentschrift: **11.03.92**

(51) Int. Cl.5: **H01L 21/00**, H01L 21/66

(21) Anmeldenummer: **86109843.2**

(22) Anmeldetag: **17.07.86**

(54) **Vorrichtung für die Prüfung und/oder Bearbeitung von Kleinbauteilen.**

(30) Priorität: **19.07.85 DE 3525866**

(43) Veröffentlichungstag der Anmeldung:
**21.01.87 Patentblatt 87/04**

(45) Bekanntmachung des Hinweises auf die
Patenterteilung:
**11.03.92 Patentblatt 92/11**

(84) Benannte Vertragsstaaten:
**AT BE CH DE FR GB IT LI LU NL SE**

(56) Entgegenhaltungen:
EP-A- 0 014 119
GB-A- 1 278 785
US-A- 3 695 414

(73) Patentinhaber: **Herrmann, Jakob**
**821 Caminito Verde**
**Carlsbad, CA 92009(US)**

(72) Erfinder: **Herrmann, Jakob**
**821 Caminito Verde**
**Carlsbad, CA 92009(US)**

(74) Vertreter: **Michelis, Theodor, Dipl.-Ing. et al**
**Seibert + Michelis Rechtsanwälte und Pa-**
**tentanwälte Tattenbachstrasse 9**
**W-8000 München 22(DE)**

## Beschreibung

Die Erfindung bezieht sich auf eine Vorrichtung für die Messung und/oder Bearbeitung von Kleinbauteilen in großen Stückzahlen. Derartige Vorrichtungen werden vorwiegend als Bearbeitungsstationen in Fertigungsstraßen für die Herstellung bzw. das Messen von elektronischen Mikrobauteilen benötigt. Sie bestehen aus einem Bauteilebehälter, aus dem die Bauteile mittels eines geeigneten Bauteilträgers den Meß- bzw. Bearbeitungsstellen zugeführt werden, und von dem sie nach erfolgter Messung bzw. Bearbeitung mittels einer geeigneten Auswurfvorrichtung in ein zweites Bauteilemagazin ausgeworfen werden.

Eine typische Gestaltungsform einer derartigen Vorrichtung zeigt die DE-OS 28 10 654. Der Bauteilebehälter ist hier ein Rüttel-Schwingförderer, mittels dessen die Bauteile in einer bereits ausgerichteten Position dem als Scheibe ausgebildeten Bauteilträger zugeführt werden. Die Bearbeitungsstellen sind dabei seitlich von der Scheibe oder oberhalb bzw. unterhalb der Scheibe angebracht. Nach Durchführung der Messungen bzw. Bearbeitungsgänge werden die Bauteile mittels einer pneumatisch oder auch magnetisch arbeitenden Vorrichtung aus der Halterung ausgeworfen und in einem zweiten Bauteilebehälter gesammelt.

Die Bearbeitungsgeschwindigkeit ist hierbei durch die an der Scheibe auftretenden Fliehkräfte und durch die Zugfestigkeit des Werkstoffs der Scheibe begrenzt.

Die Aufgabe der Erfindung ist es eine Vorrichtung für die Prüfung und/oder Bearbeitung von Kleinbauteilen aufzuzeigen, die eine größere Durchsatzmenge pro Zeiteinheit ermöglicht als die bisher bekannten Ausführungsformen. Diese Aufgabe wird mit einer Vorrichtung mit den im Anspruch 1 genannten Merkmalen gelöst.

Bei der Vorrichtung gem. der vorliegenden Erfindung, die im besonderen zum Prüfen von stirnkontaktierten passiven Mikrobauelementen bestimmt ist, ist dabei in einer besonders vorteilhaften Ausführungsform als Bauteilträger ein Band mit einer Lochreihe zur Aufnahme der Bauelemente vorgesehen, wobei das Band eine zweite Lochreihe aufweist, deren einzelnen Löcher eine festen Zuordnung zur Anordnung der Löcher der ersten Lochreihe aufweisen, so daß durch Abtasten mit einem Positionierungselement der Löcher der zweiten Lochreihe die genaue Lage der in den Löchern der ersten Lochreihe vorhandenen Bauelemente deriniert werden kann.

Dabei ist das als Bauteilträger zu verwendende Band vorzugsweise als Endlosband ausgebildet und wird kontinuierlich oder schrittweise in dem Fortgang der Prüfung bzw. Bearbeitung gesehen zunächst unter einem entsprechend langgestreckten Bauteilebehälter bzw. dessen unteren Öffnung vorbeigeführt. Dabei ist gem. einer anderen vorteilhaften Weiterbildung die als Entnahmeöffnung dienende untere Öffnung so lang gestreckt ausgeführt, daß jedes einzelne Loch der zur Aufnahme der Bauteile vorgesehenen Lochreihe des Bandes möglichst lange unter der Entnahmeöffnung geführt ist, ehe es den Bereich des Bauteilebehälters verläßt und in den Bereich der Meß- und/oder Bearbeitungsstation gelangt.

Auf diese Weise wird dann ein ausreichend hoher Füllgrad der Löcher des Transportbandes erreicht, da das sich bewegende Band die ungeordnet in dem Bauteilebehälter vorhandenen Bauteile umwälzt, die dabei in eines der freien Löcher des Bandes fallen können.

Als Antrieb für die schrittweise Bewegung des als Bauteilträger dienenden Bandes kann an sich jeder Schrittantrieb einschließlich eines Malteserkreuzes eingesetzt werden. Gem. einer vorteilhaften Ausgestaltung empfiehlt sich die Verwendung eines Gleichstrommotors (DC-Motors) mit schrittweisem Antrieb, dessen Bewegung der Rotorwelle mittels eines Zahnriemens auf eine Antriebsrolle, insbesondere eine Umlenkrolle bei Verwendung eines Endlosbandes übertragen wird.

Die Abtastung der jeweiligen Lage mittels eines Positionierungselements erfolgt gem. einer anderen vorteilhaften Weiterbildung unter Verwendung eines Schwingarmes an dem außer dem Positionierungselement auch das Kontaktelement bzw. ein Werkzeug befestigt ist. Dabei wird vorzugsweise das Positionierungselement in Form eines Stiftes ausgeführt, dessen Durchmesser wenig größer ist als der Durchmesser eines Positionierungsloches ist und der an seiner dem Positionierungsloch in dem Band zugewandten Seite in eine kegel- oder kugelförmige Spitze ausläuft. Durch eine derartige Ausbildung wird eine gute Dämpfung des Positionierungselementes beim Aufsetzen erreicht, da mit der kegel- oder kugelförmigen Spitze in dem Positionierungsloch ein Luftpolster gebildet wird, das selbst bei hohen Taktzeiten der Vorrichtung ein sanftes Aufsetzen des am Kopf des Schwingarmes befestigten Kontaktes auf das Bauteil garantiert, was für die Kontaktierung des zu messenden Bauteils wesentlich ist, da dort einerseits ein Prellen des Kontaktes und andererseits ein zu hartes Auftreffen des Kontaktes mit zu hoher Kraft, was zu Beschädigungen führen könnte, vermieden wird.

Weitere Merkmale der Erfindung und vorteilhafte Ausgestaltungen werden im folgenden anhand der beiliegenden Zeichnung näher beschrieben. Dabei zeigen die Zeichnungen nur die für das Verständnis der Erfindung notwendigen Teile einer Vorrichtung zum Prüfen von passiven Mikrobauteilen, wie Widerständen mit Stirnkontaktierung usw.

in folgenden einzelnen Details:

Fig. 1    schematisch eine Seitenansicht einer Prüfvorrichtung für derartige Bauelemente,

Fig.2    eine Draufsicht auf das Bauteilemagazin mit einem Abschnitt des Lochbandes,

Fig. 3.    die Draufsicht auf ein Lochband bei abgenommenem, Bauteilemagazin mit Umlenkrollen und einer Antriebseinheit,

Fig. 4    die Seitenansicht eines Armes in einer Meß- bzw. Bearbeitungsstelle und

Fig.5    die Draufsicht auf eine Ausführungsform nach Fig. 4.

In den Fign. ist mit 1 jeweils ein Transportband bezeichnet, das gem. der vorliegenden Erfindung zur Aufnahme der gem. dem Ausführungsbeispiel zu messenden oder zu prüfenden Microbauelementen bestimmt ist. Hierzu hat das Band 1 eine Reihe von Löchern 2, in welche in im einzelnen noch zu erläuternden Weise die Bauelemente, die zunächst ungeordnet in einem Magazin 13 eingefüllt wurden, fallen und transportiert werden. Parallel zu der Lochreihe 2 für die Bauelemente ist eine zweite Lochreihe 3 vorgesehen, die für das Einrasten eines geeigneten Positionierungselementes 9 vorgesehen ist.

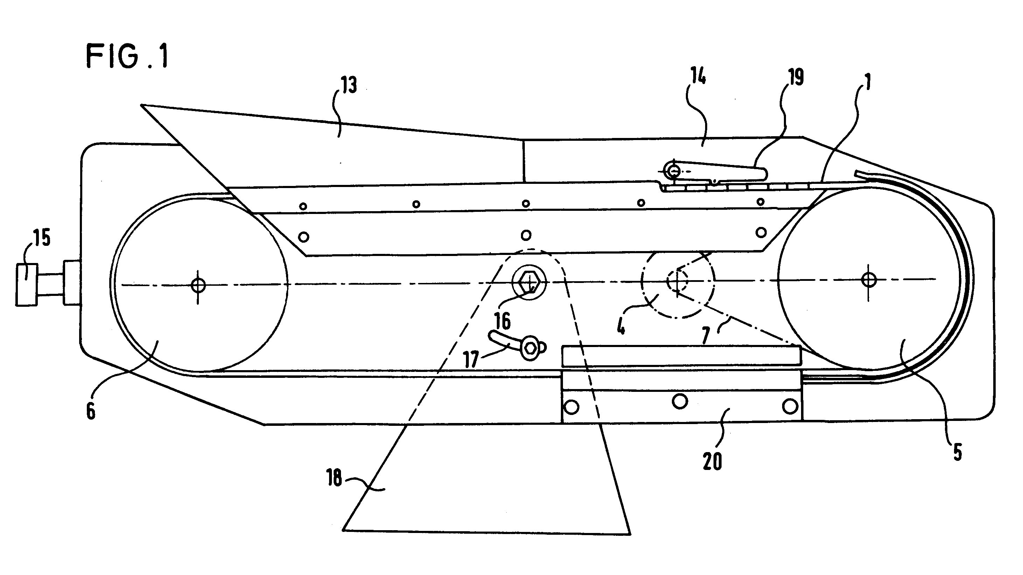

Im folgenden sei zunächst anhand der Fig. 1 in einer Seitenansicht der Grundaufbau einer Vorrichtung nach der Erfindung erläutert. Bei dieser Ausführungsform ist das Band 1 als Endlosband ausgebildet, das über die beiden Umlenkrollen 5 und 6 geführt ist. Die beiden Umlenkrollen sind drehbar in einem Rahmen 14 gehalten, wobei mittels einer Spannschraube 15 in einer im einzelnen nicht dargestellten Weise das Band entsprechend gespannt werden kann. Der gesamte Rahmen 14 ist über eine Klemmvorrichtung 16 mit Langlochführung 17 schwenkbar an einem Ständer 18 gehalten. Die Schwenkbarkeit ist vorgesehen, um das Band 1 in Laufrichtung leicht entsprechend Größe und Dicke der einzelnen zu vereinzelnden Bauelemente neigen zu können, um sie einer nur schematisch dargestellten Meßstelle 19 zuführen zu können.

Das Band wird über die Umlenkrolle 5 abhängig von einem ebenfalls nur schematisch angedeuten DC-Motor 4 über einen Zahnriemen 7 schrittweise angetrieben.

Im Bereich einer Abwurfvorrichtung 20 werden die einzelnen in der Meßstelle 19 geprüften Bauelemente entsprechend ihren Meßwerten sortiert ausgeworfen.

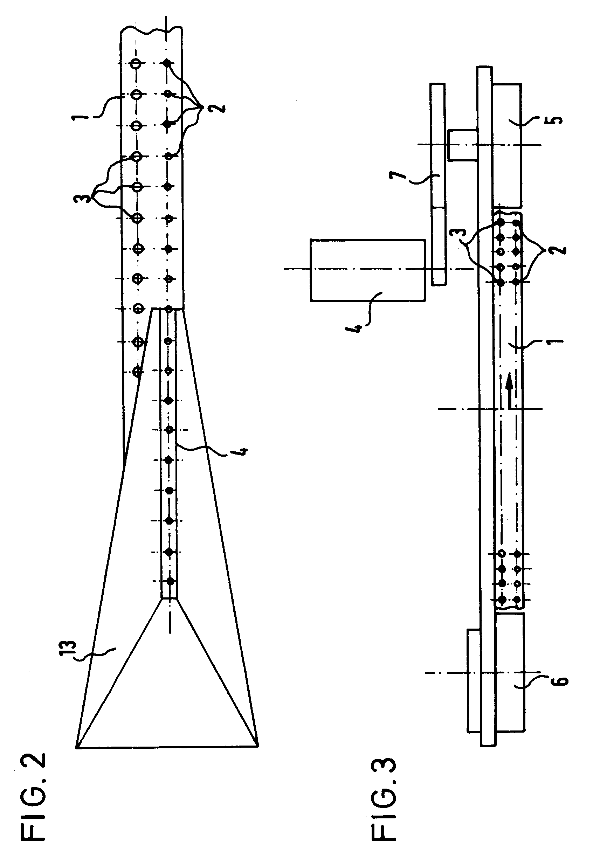

Die Fig. 2 zeigt eine Draufsicht auf den Bereich des Bandes 1 mit Bauteilebehälter 13 bei weggenommen Meßstation 19. Der Bauteilebehälter 13 ist dabei so geformt, daß das schrittweise an seinem Boden vorbeigeführte Band 1 über eine mehrere Löcher umfassende Länge vorbeigeführt wird, wobei die auf dem Band 1 zunächst teilweise noch lose aufliegenden Bauelemente durch jeden Transportschritt so durchmischt und gerüttelt werden, daß sie in die noch freien Löcher 2 des Bandes 1 fallen. Praktische Versuche haben ergeben, daß mit einer derartigen Anordnung ein Füllgrad von etwa 95 % erreicht werden kann.

Die Fig. 3 zeigt das Band 1 mit den beiden Umlenkrollen 5 und 6, wobei, wie schon anhand der Fig. 3 angedeutet, ein Zahnriemen 7 als Triebverbindung zwischen der Welle des Antriebsmotors 4 und der Welle des Umlenkrades 5.

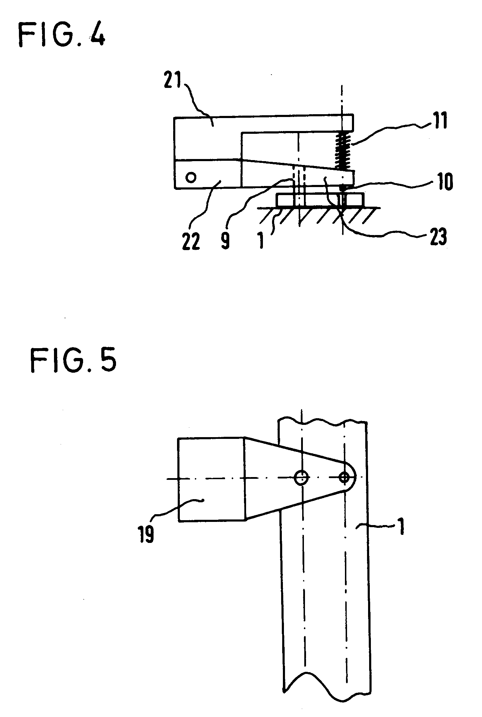

Bei dem dargestellten Ausführungsbeispiel ist davon ausgegangen, daß relativ kurze in ihrer Länge der Dicke des Transportbandes nahezu entsprechende Bauelemente in den Löchern 2 des Bandes 1 zu einer Meßstelle transportiert werden, wobei zumindest im Bereich der Meßstelle 19, die in der Fig. 1 nur schematisch angedeutet ist, das Band auf einer metallischen Unterlagen gleitet, so daß die unteren Kontakte der stirnkontaktierten Bauelemente in metallischem Kontakt mit der Unterlage stehen. Im Takt des Transportes wird dann eine in Einzelheiten in den Fign. 4 in Seitenansicht und in Fig. 5 dargestellte Positionierungs- und Abtasteinheit jeweils entsprechend dem Fortschaltzyklus angehoben und auf die Bauelemente abgesetzt wird. Dabei hat jede Positionierungs-Kontaktiereinheit 19 einen Schwingarm 23, der um die Achse 22 in gewissem Umfang leicht drehbar an einem Haltebügel 21 befestigt ist. An dem Schwingarm 23 ist einerseits das Positionierungselement 9, das jeweils auf eines der Löcher 3 des Bandes 1 abgesetzt wird, und andererseits ein Kontaktelement 10, das sich auf den oberen Kontakt des in der entsprechenden Öffnung 2 gehaltenen und geführten Bauelementes aufsetzt, befestigt. Der nötige Kontaktdruck wird mit Hilfe einer Feder 11 aufrechterhalten.

Der Kontaktstift 9 hat an seiner den Löchern 3 zugewandten Seite eine halbkugelförmige Spitze, die sein jeweils auf das entsprechende Loch 3 absetzt und dabei eine Dämpfung der Absetzbewegung hervorruft. Durch die Gestaltung der Spitze als Halbkugel - oder ggf. auch als flacher Kegel - wird nämlich in dem Positionierungsloch 3 eine Kompression der in der Lochung befindlichen Luft erzeugt, die damit das Aufsetzen des Positionierungshebels und insbesondere damit auch des am Kopf des Schwingarms 23 befindenden Kontaktes 10 auf das entsprechende Bauelement so dämpft, daß eine Beschädigung oder sogar Zerstörung des Bauelementes, das aus Keramik gefertigt sein kann, selbst bei hohen Taktzeiten vermieden wird.

Die Erfindung wurde anhand eines konkreten Ausführungsbeispiels erläutert. Für den auf dem Fachgebiet tätigen Fachmann ergibt sich, daß durch die Verwendung eines Bandes eine besonders hohe Taktzeit erreicht werden kann, die mit bisherigen Vereinzelungs- und Prüfautomaten nicht erreicht werden konnte. Dabei erkennt der Fachmann, daß die Ausgestaltung des Aufnahmebereiches für die einzelnen zu prüfenden Bauteile oder anderen Objekte in einfacher Weise diesen Objekten angepaßt werden kann, wobei auch Schräglagen, Mulden usw. je nach dem gewünschten Bearbeitungsweck vorgesehen werden können. Dementsprechend muß auch für die Positionierung bzw. die Überwachung der richtigen Positionierung nicht notwendigerweise eine zweite Lochreihe vorgesehen werden. Es ist, durchaus auch denkbar, die Positionierungsöffnungen seitlich an der, Stirnseite des Bandes oder aber auch durch Ausnehmungen im Rand des Bandes vorzusehen, wenn beispielsweise, z.B. bei dem Bedrucken einzelner Bauelemente, auf die Dämpfungswirkung, die mit einem Positionierungsstift und einem Positionierungsloch in der vorbeschriebenen einfachen Weise erreicht werden kann, verzichtet werden kann.

Ferner kann jede andere Art von Markierungsmerkmalen auf dem Trägerband mittels einer geeigneten optischen oder elektronischen Abtastvorrichtung zur Positionierung des Trägerbandes beim Meß- bzw. Bearbeitungsvorgang dienen. Weiter sind auch Meß- bzw. Arbeitsgänge denkbar, bei denen auf der Positionierung des Trägerbandes bei dem Meß- bzw. Bearbeitungsvorgang verzichtet werden kann.

Außerdem ist die Ausführung der Erfindung auch mit einem kontinuierlichen Vortrieb des Trägerbandes unter der Entnahmeöffnung des Bauteileträgers möglich. Versuche haben jedoch gezeigt, daß mit einer erfindungsgemäßen Gestaltung der Vorrichtung, wie sie in den Abbildungen gezeigt ist, bei einem schrittweisen Vortrieb des Trägerbandes unter der Entnahmeöffnung des Bauteilebehälters ein höherer Füllgrad der Löcher für die Aufnahme der Bauteile erreicht wird.

## Patentansprüche

1. Vorrichtung zum Zuführen einzelner elektronischer Kleinbauteile, insbesondere elektronischer Mikro-Chips, zu einer Meß- und/oder Bearbeitungsstation (19) aus einem Bauteilebehälter (13), der die Bauteile zunächst ungeordnet aufnimmt und aus einer untenliegenden Öffnung einem an der Öffnung vorbeigeführten Bauteileträger in Form eines Bandes (1) mit einer oder mehreren parallelen Reihen von Aufnahmestellen (2) sowie mit einer parallelen Reihe von Positionierungslöchern (3) zur Lageerkennung vereinzelt und ausgerichtet zuführt und der Meß- oder Bearbeitungsstation (19) zuleitet, wobei die Meß- oder Bearbeitungsstation (19) aus einem quer über das Band (1) ragenden Schwingarm (21) besteht, an dem nebeneinander ein Werkzeug oder Kontaktelement (10) für den Bearbeitungs- oder Meßvorgang sowie ein Positionierungselement (9) zum gedämpften Aufsetzen des Werkzeugs oder des Kontaktelementes (10) befestigt sind, und wobei ein Federelement (11) den Schwingarm (21) gegen das Bauteil drückt.

2. Vorrichtung nach Anspruch 1, bei der das Positionierungselement aus einem senkrecht aus dem Schwingarm (21) herausragenden Stift (9) mit einer kegel- oder kugelförmigen Spitze besteht, deren Durchmesser geringfügig größer als der Durchmesser eines Positionierungsloches (3) im Band (1) ist.

## Claims

1. Device for supplying individual electronic microcomponents, in particular electronic micro-chips, to a measuring and/or processing station (19) from a component container (13) which receives the components at first in a random state and then supplies them sorted and aligned out of a bottom opening to a component carrier, in the form of a band (1) having one or more parallel rows of receiving points (2) and having a parallel row of positioning holes (3) for position recognition which is conveyed past the opening, and directs them to the measuring or processing station (19), with the measuring and processing station (19) comprising a rocker arm (21) which projects transversely over the band (1) and on which are fastened adjacent to one another a tool or contact element (10) for the processing or measuring procedure and a positioning element (9) for cushioned application of the tool or the contact element (10), and with a spring element (11) pressing the rocker arm (21) towards the component.

2. Device according to claim 1, in which the positioning element comprises a pin (9) with a conical or spherical tip, which projects at right angles from the rocker arm (21) and whose diameter is slightly greater than the diameter of a positioning hole (3) in the band (1).

## Revendications

1. Dispositif pour envoyer des micromodules électroniques individuels, notamment des microplaquettes électroniques, à un poste de mesure et/ou de traitement (19) à partir d'un récipient (13), qui reçoit les composants tout d'abord dans un état désordonné et les envoie séparément et d'une manière alignée à partir d'une ouverture inférieure, à un porte-composants qui se déplace devant l'ouverture et se présente sous la forme d'une bande (1) possédant une ou plusieurs rangées parallèles de postes de réception (2), ainsi qu'une rangée parallèle de trous de positionnement (3) permettant une identification de position, et les envoie au poste de mesure ou de traitement (19), et dans lequel le poste de mesure ou de traitement (19) est constitué par un bras oscillant (21), qui fait saillie transversalement audessus de la bande (1) et auquel sont fixés, côte-à-côte, un outil ou un élément de contact (10) pour l'opération de traitement ou de mesure, ainsi qu'un élément de positionnement (9) pour la mise en place amortie de l'outil ou de l'élément de contact (10), et dans lequel un élément de ressort (11) repousse le bras oscillant (21) contre le composant.

2. Dispositif suivant la revendication 1, caractérisé par le fait que l'élément de positionnement est constitué par une tige (9), qui fait saillie perpendiculairement hors du bras oscillant (21) et comporte une pointe conique ou sphérique, dont le diamètre est légèrement inférieur au diamètre d'un trou de positionnement (3) ménagé dans la bande (1).

FIG.1

EP 0 209 144 B1

FIG. 2

FIG.3

EP 0 209 144 B1

## FIG. 4

## FIG. 5